# EUROPEAN PATENT APPLICATION

(11) **EP 1 555 700 A2**
(43) Date of publication of application: **20.07.2005**
(21) Application number: 05000519.8
(22) Date of filing: 12.01.2005
(51) Int. Cl.: H01L 45/00, H01L 29/68, H01L 21/8246, H01L 27/112

(54) **Method for manufacturing a nonvolatile memory device with a variable resistor**

(30) Priority: 13.01.2004 JP 2004004949
(71) Applicant: Sharp Kabushiki Kaisha, Osaka-shi, Osaka 545-8522 (JP)
(72) Inventor: Kawazoe, Hidechika, Kitakatsuragi-gun Nara 636-0081 (JP); Tamai, Yukio, Fukuyama-shi Hiroshima, 721-0926 (JP); Shimaoka, Atsushi, Kashihara-shi Nara, 634-0008 (JP); Hagiwara, Naoto, Harunamachi Gumma-gun Gumma, 370-3342 (JP); Matsushita, Yuji, Takasaki-shi Gumma, 370-0881 (JP); Nishi, Yuji, Gumma, 370-3102 (JP)
(74) Representative: Müller - Hoffmann & Partner

(57) **Abstract**

In a manufacturing method of a nonvolatile semiconductor memory device including a variable resistive element having a variable resistor (8) made of a perovskite-type metal oxide film, the variable resistor (8) is formed at a temperature which is lower than the melting point of a metal wire layer (11) that has been formed before formation of the variable resistor (8). More preferably, the variable resistor (8) is formed by a praseodymium calcium manganese oxide, which is represented by a general formula, Pr₁₋ₓCaₓMnO₃, carried out at a film forming temperature in a range from 350°C to 500°C according to a sputtering method.

## Description

### BACKGROUND OF THE INVENTION

### 1. Field of the Invention

The present invention relates to a nonvolatile semiconductor memory device and, more specifically, to a manufacturing method of a nonvolatile semiconductor memory device including a variable resistive element having a variable resistor made of a perovskite-type metal oxide film.

### 2. Description of the Related Art

In recent years, a variety of device structures such as an FeRAM (Ferroelectric RAM), an MRAM (Magnetic RAM) and an OUM (Ovonic Unified Memory) have been proposed as a next generation nonvolatile random access memory (NVRAM) that makes a rapid operation possible substituting a flash memory, and there has been a fierce competition for the development of such devices from the standpoint of increase in performance, increase in reliability, cost reduction and process matching. However, these memory devices at the present stage have their merits and demerits, and there is a long way to go before the realization of an ideal "universal memory" which has the respective merits of an SRAM, a DRAM and a flash memory.

The FeRAM, for example, which has already been put into practice, utilizes a spontaneous polarization inversion phenomenon of oxide ferroelectrics and is characterized by a low consumed power and a high speed operation; however, it is inferior due to high cost and destructive readout. A ferromagnetic tunnel effect element that utilizes giant magnetoresistance (GMR) used in the MRAM has a structure in that two ferromagnetic layers made of Fe, Co, Ni or the like is placed between extremely thin insulating layers (tunnel barrier layers) such as Al₂O₃. Herein, an amount of tunnel current flowing via the insulating layers can be controlled by changing the orientation of magnetization (spin) of the ferromagnetic layers, thus exhibiting a memory effect. This element has a large problem of high consumed power for magnetization inversion at the time of programming and of a difficulty in miniaturization. In addition, the OUM based on thermal phase transformation of a chalcogenite material is advantageous in low cost and process matching; however, it has a problem in miniaturization and in a high speed operation due to its thermal operation.

In addition to these existing technologies, a resistive random access memory (RRAM) device, that utilizes an electrical pulse induced resistance (EPIR) effect which is a new phenomenon in a colossal magnetoresistance (CMR) material, has been disclosed (see US Patent No 6,204,139) by Shangquing Liu, Alex Ignatiev et al. of Houston University in the United States. The EPIR effect in a CMR material represented by a Mn-based oxide material having a perovskite-type structure is epoch-making where a change in resistance by several digits occurs at room temperature. The RRAM that utilizes this phenomenon has features in a low consumed power, a simple structure appropriate for miniaturization, easiness in a high integration and a wide dynamic range of a change in the resistance, and has excellent properties where a multiple value memory, which stores information of three or more values in a single memory element, is made possible. The memory element has an extremely simple basic structure where a lower electrode thin film, a CMR thin film and an upper electrode thin film are layered in sequence in the direction perpendicular to a substrate. According to the operation, the polarity, the voltage and the pulse width (widely ranging from several tens of ns to several µs) of the electrical pulse that is applied between the upper and the lower electrodes are controlled, so that the resistance of the CMR thin film that is placed between the upper and lower electrodes is changed. The resistance value that has been changed due to such a pulse application is maintained for a long period of time after the pulse application, and the performance of a nonvolatile memory element can be obtained by, for example, making the low resistance condition correspond to "0" and making the high resistance condition correspond to "1".

As the CMR material of an EPIR element, Pr₁₋ₓCaₓMnO₃ (PCMO), La₁₋ₓCaₓMnO₃, La₁₋ₓSrₓMnO₃, Gd_{0.7}Ca_{0.3}BaCo₂O₅₊₅ or the like, which have a perovskite structure, where the base is a network of oxygen octagons having a 3d transition metal element at its center, are typically used, and there has been reported that PCMO having the composition that is close to x = 0.3 has the widest range of a change in the resistance value. As the electrode material, metal-based materials such as Pt, Ir, Ru, Ph, Ag, Au, Al and Ta and oxide- or nitride-based compounds such as YBa₂Cu₃O_{7-X}, RuO₂, IrO₂, SrRuO₃, TaSiN, TiN, TiSiN and MoN which have a conductivity higher than the CMR material are used and noble metal-based materials which are superior in mass production and form an excellent interface condition with the CMR layer, causing no problems with the electrical connection and which include metals in the platinum group such as Pt (lattice constant a = 0.3923 nm), Ir (a = 0.3839 nm), Rh (a = 0.3803 nm) and Pd (a = 0.389 nm) as well as Au (a = 0.4079 nm) are appropriate.

In the case where nonvolatile memory elements are formed simultaneously with the formation of transistors at the time when the nonvolatile memory elements are fabricated in a semiconductor integrated circuit according to the prior art, heat treatment is carried out to the nonvolatile memory elements at a high temperature by diffusion annealing used for formation of transistors, so that the film quality of the perovskite-type metal oxide for the performance of the nonvolatile memory elements is changed. Accordingly, it is desirable to form the nonvolatile memory elements in the wiring process after formation of the transistors in order to integrate the nonvolatile semiconductor memory elements into the semiconductor integrated circuit. In addition, the nonvolatile memory elements can be fabricated in a layered structure by fabricating the nonvolatile memory elements in the wiring process, so that high integration becomes possible and specification change and design change of the semiconductor integrated circuit become easy.

In the wiring process of manufacturing a semiconductor integrated circuit, with Al wires, the melting point is too low, 660°C, and with Cu wires of which the specific resistance is lower than that of Al wires, Cu wires are easily to diffuse into an insulating layer at a high temperature so that the heat treatment can not be carried out after formation of the wires. As a result, it is necessary to form nonvolatile memory elements by using a low temperature process in order to add a process for fabricating nonvolatile memory elements after formation of the wires in manufacturing a semiconductor integrated circuit. A method for forming a perovskite-type metal oxide film using a low temperature process is not clarified according to the prior art disclosed in US Patent No. 6,204,139 by Houston University in the United States.

### SUMMARY OF THE INVENTION

The present invention has been made in view of the above problems, and it is therefore an object to provide a method for forming a nonvolatile memory element in a wiring process in which the high integration by a layered structure and design change are easy at the time a nonvolatile memory element having a variable resistor made of a perovskite-type metal oxide film is fabricated in a semiconductor integrated circuit, and a manufacturing method of a nonvolatile memory element that can be formed in a low temperature process not causing thermal damage in a wiring process.

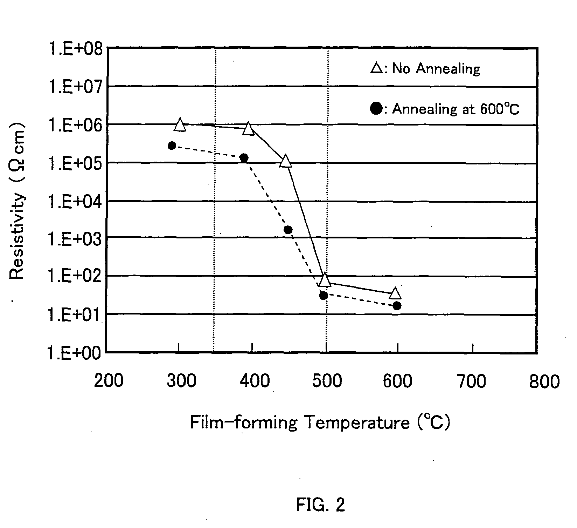

As for the relationship between the film forming temperature and the resistivity of a perovskite-type metal oxide film, in an example of a PCMO film as shown in Fig. 2, a high resistivity in the initial condition is obtained at a film forming temperature of 350 or 400°C or less, and a low resistivity in the initial condition is obtained at a film forming temperature of 500°C or more. The resistivity greatly changes in the intermediate film forming temperature between 350°C or 400°C and 500°C.

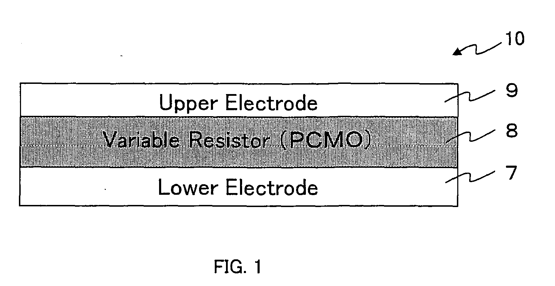

Accordingly, in a nonvolatile semiconductor memory device including a variable resistive element (see Fig. 1) having a variable resistor made of a perovskite-type metal oxide film, first, the variable resistor made of a perovskite-type metal oxide film is formed at a temperature lower than the melting point of the metal wire material; therefore, the metal wires can be prevented from receiving excessive thermal damage, so that a high quality nonvolatile semiconductor memory device can be obtained. Secondly, the resistivity of the perovskite-type metal oxide film changes depending on the film forming temperature; therefore the initial resistance can be set in accordance with the properties required for the variable resistive element without modifying the geometric dimensions, such as the film thickness of the variable resistor by adjusting film forming temperature.

More preferably, the manufacturing method is characterized in that the variable resistor is a praseodymium calcium manganese oxide represented by a general formula, Pr₁₋ₓCaₓMnO₃, of which the film has been formed at a film forming temperature between 350°C and 500°C. A Pr₁₋ₓCaₓMnO₃ (PCMO) film that has been formed at a film forming temperature between 350°C and 500°C has properties of great resistance change held by a PCMO film and, also, has the working effects described above.

More preferably, the manufacturing method is characterized in that the variable resistor is formed above the metal wire layer which is the lowermost layer. In the case where a memory cell is assumed to be formed of a variable resistive element and an active element such as a transistor, the variable resistive element and the transistor can be placed on top of each other, achieving the miniaturization of the memory cell. In addition, the variable resistor is formed in a low temperature process; therefore, the metal wire placed at the lower layer can be prevented from being thermally damaged.

A manufacturing method of a nonvolatile semiconductor memory device according to a first aspect of the present invention is a manufacturing method of a nonvolatile semiconductor memory device including a variable resistive element having a variable resistor made of a perovskite-type metal oxide film, and the variable resistor is formed at a temperature lower than the melting point of the metal wire layer that has been formed before formation of the variable resistor.

According to the manufacturing method of a nonvolatile semiconductor memory device with the first aspect, first, the variable resistor made of a perovskite-type metal oxide film is formed at a temperature lower than the melting point of the metal wire material; therefore, the metal wire can be prevented from being thermally damaged excessively, so that a high quality nonvolatile semiconductor memory device can be obtained. Secondly, the resistivity of the perovskite-type metal oxide film changes depending on the film forming temperature; therefore, initial resistance can be set in accordance with the properties required for the variable resistive element without modifying the geometric dimensions, such as the film thickness of the variable resistor by adjusting the film forming temperature.

Furthermore, the manufacturing method of a nonvolatile semiconductor memory device according to a second aspect of the present invention is a manufacturing method of a nonvolatile semiconductor memory device including a variable resistive element having a variable resistor made of a perovskite-type metal oxide film, wherein the variable resistor made of praseodymium calcium manganese oxide represented by a general formula, Pr₁₋ₓCaₓMnO₃ is formed at a film forming temperature between 350°C and 500°C.

According to the manufacturing method of a nonvolatile semiconductor memory device with the second aspect, first, the resistivity of the Pr₁₋ₓCaₓMnO₃ (PCMO) film changes depending on the film forming temperature between 350°C and 500°C; therefore, the initial resistance can be set in accordance with the properties required for the variable resistive element without modifying the geometric dimensions, such as the film thickness of the variable resistor by adjusting the film forming temperature. Secondly, the variable resistor is formed of a PCMO film at a temperature lower than the melting point of the metal wire material; therefore, the metal wire can be prevented from being thermally damaged excessively, so that a high quality nonvolatile semiconductor memory device can be obtained.

Preferably, in the manufacturing method of a nonvolatile semiconductor memory device according to any of the first and second aspects of the present invention, according to a third aspect of the present invention, the variable resistive element is formed by layering a lower electrode, the variable resistor and an upper electrode in sequence and the variable resistor is formed of a film on the lower electrode by means of sputtering in the process forming the variable resistive element.

According to the manufacturing method of a nonvolatile semiconductor memory device with third aspect, the variable resistive element is formed in such a manner that the variable resistor is placed between the lower electrode and the upper electrode; therefore, a predetermined voltage can be applied between the lower electrode and the upper electrode, so that this voltage can be applied to the variable resistor, changing the resistance value thereof and thereby, the variable resistive element formed of the lower electrode, the variable resistor and the upper electrode can function as a nonvolatile memory element. In addition, a sputtering method where parameters for film growth can be set in a wide range is used for forming the variable resistor; therefore, the formation of a high quality film at a low temperature becomes possible.

More preferably, in the manufacturing method of a nonvolatile semiconductor memory device according to the third aspect of the present invention, according to a fourth aspect of the present invention, the lower electrode and the upper electrode are formed at a temperature below a temperature, at which the variable resistor is formed, in the process of forming the variable resistive element. As a result, the metal wire that has already been formed can be prevented from being thermally damaged at the temperature, at which the lower electrode and the upper electrode are formed, so that a high quality of nonvolatile semiconductor memory device can be obtained.

More preferably, in the manufacturing method of a nonvolatile semiconductor memory device according to any of the above aspects of the present invention, according to a fifth aspect of the present invention, the variable resistor is formed at a temperature which is higher than a maximum treatment temperature in a process after formation of the metal wire layer. As a result, the variable resistor film that has been once formed is not annealed at a temperature higher than the film forming temperature; therefore, the initial resistance value that is determined by the film forming temperature can be stably maintained, so that the initial resistance value of the variable resistor can easily be adjusted.

### BRIEF DESCRIPTION OF THE DRAWINGS

Fig. 1 is a cross sectional view schematically showing the basic structure of a variable resistive element that is used in a nonvolatile semiconductor memory device according to the present invention;
Fig. 2 is a graph showing the characteristic of the relationship between the film forming temperature by sputtering and the resistivity of a PCMO film in the case where the PCMO film is formed as an example of a variable resistor of the perovskite-type metal oxide film;
Fig. 3A is a diagram of an equivalent circuit showing an example of the configuration of a memory cell that is used in the nonvolatile semiconductor memory device according to the present invention, and Fig. 3B is a cross sectional diagram schematically showing the structure of the memory cell of Fig. 3A;
Fig. 4 is a table of steps showing examples of the processes after a process of forming a first layer metal wire for manufacturing a memory cell of the nonvolatile semiconductor memory device according to the present invention;
Fig. 5 is a block diagram showing the configuration of the entirety of the nonvolatile semiconductor memory device according to the present invention;
Fig. 6 is a cross sectional diagram schematically showing another example of the memory cell structure that is used in the nonvolatile semiconductor memory device according to the present invention; and
Fig. 7 is a circuit diagram showing an example of the configuration of the memory array that is used in the nonvolatile semiconductor memory device according to the present invention.

### DESCRIPTION OF THE PREFFERED EMBODIMENTS

One embodiment of a nonvolatile semiconductor memory device according to the present invention (hereinafter, appropriately referred to as "inventive device") is described below with reference to the drawings.

Fig. 1 is a cross sectional diagram showing the basic structure of a variable resistive element 10 which is a nonvolatile memory element used in an inventive device 100. The basic element structure of variable resistive element 10 is a layered structure where a lower electrode 7, a variable resistor 8 made of a perovskite-type metal oxide film, and an upper electrode 9 are layered in sequence.

As for the perovskite-type metal oxide that is used as the variable resistor 8, a great number of examples such as Pr₁₋ₓCaₓMnO₃ (PCMO), Pr₁₋ₓ(Ca,Sr)ₓMnO₃, Nd_{0.5}Sr_{0.5}MnO₃, La₁₋ₓCaₓMnO₃, La₁₋ₓSrₓMnO₃ and Gd_{0.7}Ca_{0.3}BaCo₂O₅₊₅ are known. Among these, Pr₁₋ₓCaₓMnO₃-based materials, which have a large distortion in the network of the transition metal-oxide bonding and where a charge order phase is easily formed due to the suppression of charge transfer resulting from the distortion, exhibit a greater EPIR effect and moreover, the composition which is in the proximity of the phase border that is close to x = 0.3 where a fusion phenomenon of the charge order phase easily occurs due to an external disturbance is preferable as the material used for the variable resistor 8 of the present invention that exhibits the EPIR effect.

As for the lower electrode 7, single noble metals including metals in the platinum group represented by Pt, Pd, Rh and Ir which have a high level of lattice matching with a perovskite-type metal oxide and have a high conductivity and a high resistance to oxidation and alloys between such noble metals as well as a variety of alloys of which the bases are these metals are preferable.

On the other hand, the upper electrode 9 is not necessarily exposed to an oxygen atmosphere at a high temperature; therefore, it is not limited to the above noble metal elements but rather a variety of materials such as Al, Cu, Ni, Ti and Ta, as well as oxide conductors are applicable. Here, a barrier layer may appropriately be inserted between the lower electrode and the base substrate in order to prevent reaction and to improve adhesion. In the case where an electrical connection is secured between the substrate and the lower electrode when a silicone substrate is used, for example, a significant conversion to an alloy occurs between Pt and Si; therefore, insertion of Ti, TiN, Ti_{1-X}Al_{X}N, TaN, TiSiN, TaSiN or the like, which has a conductivity and a barrier function, is effective. In the case where the substrate is coated with a SiO₂ layer, use of TiOx, IrO₂ or the like, which is an oxide causing no problems with the oxidation, is effective though the barrier layer mentioned above can be applied.

As for a technique for film formation of the lower electrode 7, a variety of techniques such as a sputtering method, a vacuum deposition method, an MOCVD (Metal Organic Chemical Vapor Deposition) method can be appropriately used, however a sputtering method, where parameter for film growth can be set in a wide range, is preferable from the standpoint of orientation control and stress control.

As for a technique for film formation of a perovskite-type metal oxide film that is used as the variable resistor 8, a sputtering method is used. Fig. 2 shows dependency of the resistivity of a PCMO film on the film forming temperature where the film has a high resistance at a film forming temperature of 350°C or less. In the case of high resistance, a high voltage becomes necessary as the program and erasure voltage for the nonvolatile memory elements and may be higher than the operation voltage of the semiconductor integrated circuit. In addition, miniaturization of the nonvolatile memory elements causes an increase in the resistance.
According to the present invention, the film forming temperature within a range from 350°C to 500°C is used, so that the initial resistance value can be adjusted to form a PCMO film which allows for a switching operation in a desired range of the operation voltage and which can still be formed in a low temperature process.

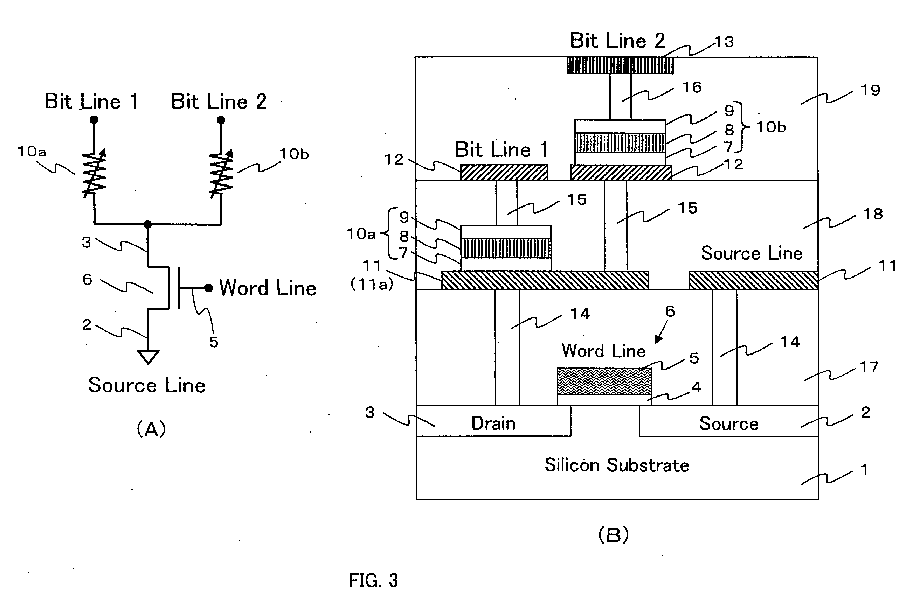

Next, a memory cell configuration which is provided with two variable resistive elements 10a and 10b as illustrated in Fig. 3 and which is formed by a process for three layers of metal wires is described. This memory cell is, as shown in the equivalent circuit of Fig. 3A, formed of the two variable resistive elements 10a and 10b and a selective transistor made of a MOSFET for selecting the memory cell. In this memory cell configuration, a selective transistor 6 is turned ON by means of the word line potential so as to select the memory cell, and in addition, a predetermined readout, program or erasure voltage is applied to one of two bit lines 1 and 2 and thereby, one of the variable resistive elements 10a and 10b is selected within the selected memory cell.

Fig. 3B shows the structure of a cross section of the configuration. The selective transistor 6 is formed of a source region 2 and a drain region 3 which are fabricated in a semiconductor substrate 1 and of a gate electrode 5 formed on a gate oxide film 4, where the drain region 3 is electrically connected to the respective lower electrodes 7 of the two variable resistive elements 10a and 10b. A first layer metal wire 11 is formed beneath two variable resistive elements 10a and 10b, and a portion of the first layer metal wire 11 is connected to the source region 2 via a contact 14 so as to be used to form a source line and the other portion is connected to the drain region 3 via the contact 14 so as to be used as a relay electrode 11a for the two lower electrodes 7. A second layer metal wire 12 is formed above the variable resistive element 10a on the lower level and a portion of the second layer metal wire is connected to the upper electrode 9 of the variable resistive element 10a on the lower level via a first via 15 so as to be used to form the bit line 1 and the other portion is used to relay the lower electrode 7 of the variable resistive element 10a on the lower level and the relay electrode 11a. A third layer metal wire 13 is formed above the variable resistive element 10b on the upper level and is connected to the upper electrode 9 of variable resistive element 10b on the upper level via a second via 16 so as to be used to form the bit line 2. As described above, the two variable resistive elements 10a and 10b are formed above the selective transistor 6, thus enabling a high density integration of the memory cells. Here, the contacts 14 are provided in a first interlayer insulator 17 between the semiconductor substrate 1 and the first layer metal wire 11, the first vias 15 are provided in a second interlayer insulator 18 between the first layer metal wire 11 and the second layer metal wire 12 and the second via 16 is provided in a third interlayer insulator 19 between the second layer metal wire 12 and the third layer metal wire 13 in order to electrically connect the upper layer and the lower layer.

In the memory cell configuration illustrated in Fig. 3, the two variable resistive elements 10a and 10b are formed during the wiring processes for the three layers of the metal wires after the process of forming the transistor in the semiconductor integrated circuit. In the case where Cu wires, of which the specific resistance is lower than that of an Al wire, are utilized instead of Al wires of which the melting point is 660°C that is too low in the wiring processes, Cu is easily diffused into the insulating layers at a high temperature; therefore, heat treatment at a temperature of not more than 500°C is carried out on the formation of the variable resistive elements 10a and 10b, including the formation of the electrodes, in order to prevent first and second layer metal wires 11 and 12 from being thermally damaged.

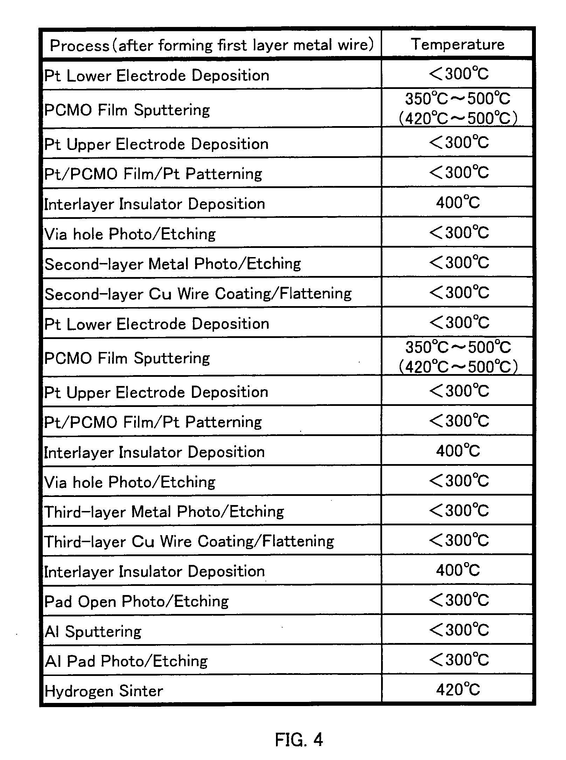

Fig. 4 shows an example of a process for fabricating the two variable resistive elements 10a and 10b in a semiconductor integrated circuit that has been manufactured in a process for metal wires of three layers where Cu wires are used as the second and third layer metal wires. The right column in the process table shown in Fig. 4 indicates treatment temperatures in the respective processes. In the present example of the process, Al pads are fabricated on the third layer metal wire. As is clear from Fig. 4, the maximum temperature after the process of forming the first interlayer insulator 17 and the first layer metal wire 11 is 420°C; therefore, in the case where the film forming temperature of the PCMO film 8 is set in a range from 420°C to 500°C, Cu can be suppressed from diffusing into the interlayer insulators and the PCMO film 8 that is not affected by heat treatment in the process for the formation of interlayer insulators and wires can be formed.

In the case where the film forming temperature of the PCMO film 8 is set at 420°C or less, the PCMO film ends up being annealed at a temperature for depositing interlayer insulators and in heat treatment of H₂ sintering causing the initial resistance value of the PCMO film to be changed. As shown in Fig. 2, in the case where an annealed process is carried out at 600°C which is higher than the film forming temperature after film formation, the resistivity is lowered in the case where the film has been formed at a film forming temperature of 500°C or less. Here, the change in the resistivity after the PCMO film that has been formed at 300°C is annealed at 600°C is smaller than the change in the resistivity due to a change in the film forming temperature (from 300°C to 600°C); therefore, it is considered that the change in the resistivity of the PCMO film is affected by the annealing temperature to a small degree. Accordingly, the optimal film forming temperature of the PCMO can be determined by taking the change in the resistivity of the PCMO film due to the temperature for H₂ sintering into consideration.

Next, an example of the configuration wherein memory cells, each of which is the same as the variable resistive element 10 that is fabricated in the above-described process, are arranged in array form so that a memory array 101 can be formed as the inventive device 100, which is a nonvolatile semiconductor memory device having a large capacity, is described with reference to the drawings.

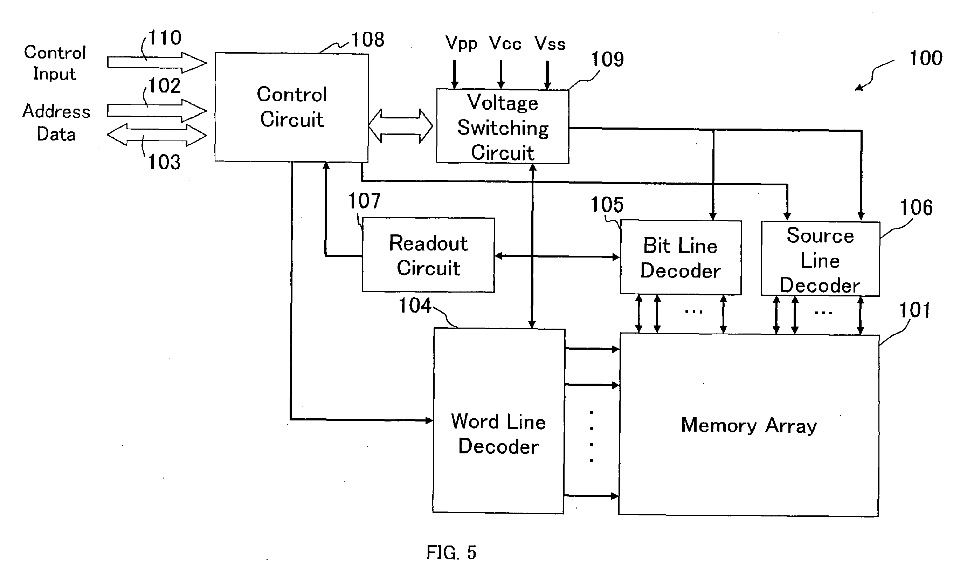

Fig. 5 shows a block diagram of the inventive device 100. Information is stored in the memory array 101 of the inventive device 100 where the memory array 101 has a configuration of a plurality of memory cells that is arranged as described above, and information can be stored in and read out from a memory cell within the memory array 101.

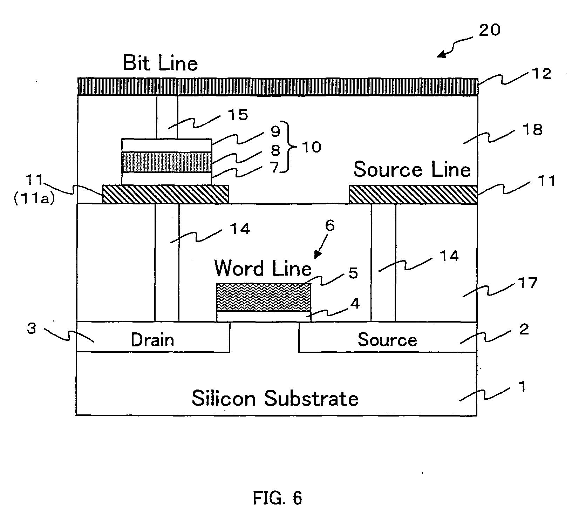

Fig. 6 shows a schematic diagram of a cross section of the memory cell 20 that forms the memory array 101. As shown in Fig. 6, the memory cell 20 is formed of: a source region 2 and a drain region 3 that have been formed on a semiconductor substrate 1; a selective transistor 6 made of a gate electrode 5 that has been formed on a gate oxide film 4; and a variable resistive element 10 where a variable resistor 8 of which the resistive value changes depending on an applied voltage is placed between a lower electrode 7 and an upper electrode 9, wherein the drain region 3 and the lower electrode 7 are electrically connected in series. In addition, the upper electrode 9 is connected to a second layer metal wire 12 which is used as a bit line; the gate electrode 5 is connected to a word line; and the source region is connected to a diffusion layer or a first layer metal wire 11 which becomes a source line. The variable resistive element 10 is formed in the same manner as the single variable resistive element 10 shown in Fig. 1. This memory cell configuration differs from that illustrated in Fig. 3 in the way that the single memory cell is formed of one variable resistive element 10. The number of the variable resistive elements 10 arranged within one memory cell may be determined in accordance with the characteristics and functions of the entire configuration of the memory device.

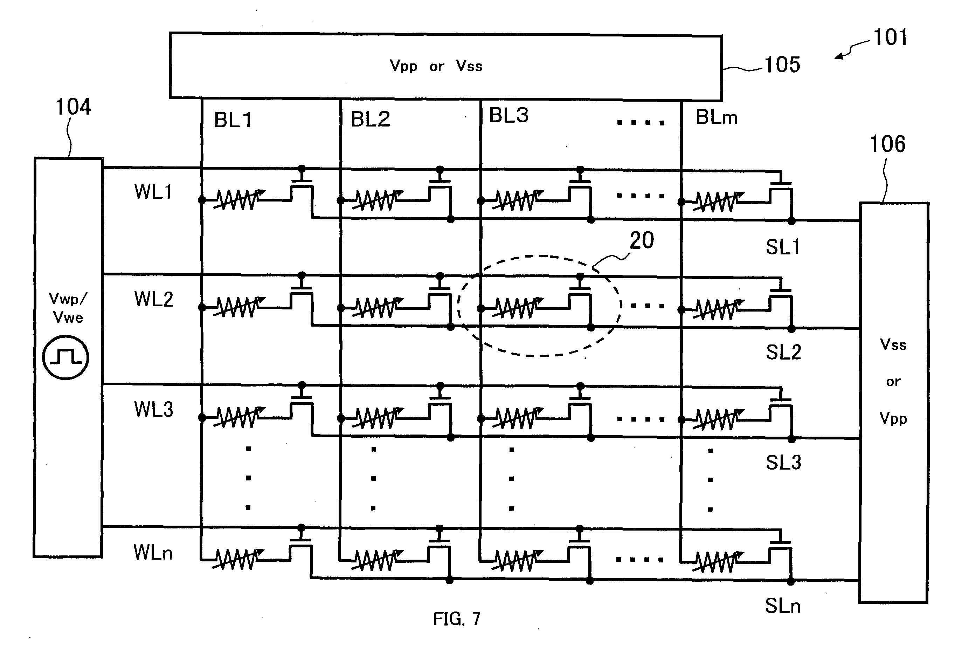

Fig. 7 schematically shows an example of the configuration of the memory array 101. In this configuration, the memory array 101 has m × n memory cells 20 at intersections of m bit lines (BL1 to BLm) and n word lines (WL1 to WLn). In addition, n source lines (SL1 to SLn) are placed in parallel to the word lines in the configuration. Here, the configuration of the memory array 101 is not limited to that of Fig. 7.

As described above, a memory cell 20 is formed of a series circuit of a selective transistor 6 and a variable resistive element 10 and thereby, the selective transistor 6 of the memory cell 20, which is selected by the potential of a word line, is turned ON and in addition, a program or erasure voltage is selectively applied to only the variable resistive element 10 of the memory cell 20 which has been selected by the potential of a bit line, and thereby, the resistance value of the variable resistor 8 in the variable resistive element 10 is changed in the configuration.

The block configuration that includes the peripheral circuits of the inventive device 100 shown in Fig. 5 is the same as or similar to the block configuration of a general nonvolatile semiconductor memory device. The each circuit blocks are briefly described below. Information is stored in a specific memory cell within the memory array 101 that corresponds to the address that has been inputted from the address line 102 and this information passes through the data line 103 so as to be outputted to an external device. A word line decoder 104 selects a word line of the memory array 101 which corresponds to the signal that has been inputted to the address line 102 and a bit line decoder 105 selects a bit line of the memory array 101 which corresponds to the address signal that has been inputted to the address line 102 and furthermore, a source line decoder 106 selects a source line of the memory array 101 which corresponds to the address signal that has been inputted to the address line 102. A control circuit 108 controls program, erasure and readout of the memory array 101. The control circuit 108 controls readout, program and erasure operations of the word line decoder 104, the bit line decoder 105, the source line decoder 106, the voltage switching circuit 109 and the memory array 101 based on the address signal that has been inputted from the address line 102, the data input (at the time of program) that has been inputted from the data line 103 and control input signal that has been inputted from the control signal line 110. In the example shown in Fig. 1, the control circuit 108 has functions as a general address buffer circuit, a data input/output buffer circuit and a control input buffer circuit (not shown).

The voltage switching circuit 109 supplies voltages to a word line, a bit line and a source line which are required at the time of readout, program and erasure of the memory array 101. Vcc indicates a supply voltage to the device, Vss indicates a ground voltage and Vpp indicates a voltage for program and erasure. In addition, data readout is carried out through the bit line decoder 105 and the readout circuit 107 from the memory array 101. The readout circuit 107 determines the condition of data and this result is sent to the control circuit 108 so as to be outputted to the data line 103.

Here, the block configuration of the inventive device 100 and the configuration of a memory cell illustrated in Fig. 5 are examples and can appropriately be modified in accordance with the characteristics and the like of the variable resistive element 10. For example, the memory cell 20 may be formed of a single variable resistive element 10 instead of being formed of a series circuit of the selective transistor 6 and the variable resistive element 10. Alternatively, a selective diode may be used in place of the selective transistor 6.

As described above in detail, it becomes possible in a manufacturing method of a nonvolatile semiconductor memory device according to the present invention to fabricate nonvolatile memory elements using a low temperature process in the wiring process for a semiconductor integrated circuit and thereby, it becomes possible to provide a manufacturing process which prevents the wires from being thermally damaged and to fabricate nonvolatile memory elements in a semiconductor integrated circuit in the latter half of the manufacturing process so that an increase in the integration of nonvolatile memory elements due to a layered structure becomes possible and a design change of a semiconductor integrated circuit becomes easy.

Although the present invention has been described in terms of the preferred embodiments, it will be appreciated that various modifications and alterations might be made by those skilled in the art without departing from the spirit and scope of the invention. The invention should therefore be measured in terms of the claims which follow.

## Claims

1. A manufacturing method of a nonvolatile semiconductor memory device, **characterized in that**
the nonvolatile semiconductor memory device comprises a variable resistive element having a variable resistor made of a perovskite-type metal oxide film, and
the variable resistor is formed at a temperature which is lower than the melting point of a metal wire layer that has been formed before formation of the variable resistor.

2. A manufacturing method of a nonvolatile semiconductor memory device, **characterized in that**
the nonvolatile semiconductor memory device comprises a variable resistive element having a variable resistor made of a perovskite-type metal oxide film, and
the variable resistor is formed by a praseodymium calcium manganese oxide represented by a general formula, Pr₁₋ₓCaₓMnO₃, carried out at a film forming temperature in a range from 350°C to 500°C.

3. The manufacturing method of a nonvolatile semiconductor memory device according to claim 1 or 2, **characterized in that**
the variable resistive element is formed of a lower electrode, the variable resistor and an upper electrode which are layered in sequence, and
the variable resistor is formed on the lower electrode by means of sputtering in the process of forming the variable resistive element.

4. The manufacturing method of a nonvolatile semiconductor memory device according to claim 3, **characterized in that**
the lower electrode and the upper electrode are formed at a temperature which is lower than a forming temperature of the variable resistor, in the process of forming the variable resistive element.

5. The manufacturing method of a nonvolatile semiconductor memory device according to claim 1 or 2, **characterized in that**
the variable resistor is formed at a temperature which is higher than a maximum treatment temperature for a process after formation of the metal wire layer.
